# EUROPEAN PATENT APPLICATION

(11) **EP 1 484 792 A1**
(43) Date of publication of application: **08.12.2004**
(21) Application number: 03744040.1
(22) Date of filing: 10.03.2003
(51) Int. Cl.: H01L 21/304

(54) **METHOD FOR GRINDING REAR SURFACE OF SEMICONDUCTOR WAFER**

(30) Priority: 14.03.2002 JP 2002070773; 25.12.2002 JP 2002374230
(71) Applicant: Disco Corporation, Ota-ku, Tokyo 144-8650 (JP)
(72) Inventor: FUKUDA, Kazuya, Ota-ku, Tokyo 144-8650 (JP); MORI, Takashi, Ota-ku, Tokyo 144-8650 (JP)
(74) Representative: Müller-Boré & Partner Patentanwälte
(86) International application number: PCT/JP2003/002797
(87) International publication number: WO 2003/077297

(57) **Abstract**

A semiconductor wafer back grinding method which grinds, by grinding means, the back of a semiconductor wafer having a plurality of circuits formed on the face thereof and having an outer peripheral edge of a nearly semispherical sectional shape, thereby bringing the semiconductor wafer to a predetermined thickness. Pretreatment for forming the outer peripheral edge of the semiconductor wafer into a flat surface making an angle θ, such that 80 degrees ≤ θ ≤ 100 degrees, preferably 85 degrees ≤ θ ≤ 95 degrees, with respect to the back of the semiconductor wafer is performed before the back of the semiconductor wafer is ground.

## Description

### Technical Field

This invention relates to a semiconductor wafer back grinding method which grinds, by grinding means, the back of a semiconductor wafer having a plurality of circuits formed on its face and having an outer peripheral edge of a nearly semicircular sectional shape, thereby bringing the semiconductor wafer to a predetermined thickness.

### Background Art

For production of a semiconductor chip, as is well known among people skilled in the art, the face of a nearly disk-shaped semiconductor wafer is divided into a plurality of rectangular regions by a plurality of streets arranged in a lattice pattern, and a circuit is formed in each of the resulting divisions. Then, the back of the semiconductor wafer is ground to reduce the semiconductor wafer to a predetermined thickness. Then, the semiconductor wafer is cut along the streets to separate the plural rectangular regions individually, thereby producing semiconductor chips. In recent times, a so-called prior dicing method has been carried out in which prior to grinding of the back of the semiconductor wafer, grooves are formed along the plural streets on the face of the semiconductor wafer, and then the back of the semiconductor wafer is ground to make the thickness of the semiconductor wafer smaller than the depth of the grooves, whereby the plural rectangular regions are separated individually. Grinding of the semiconductor wafer is carried out by attracting the semiconductor wafer onto a chuck having a flat surface, with the back of the semiconductor wafer being exposed upward, and rotationally driving the chuck while pressing rotationally driven grinding means against the back of the semiconductor wafer. Grinding means of a form having a plurality of grinding wheels overall annular in shape or a single continuous annular grinding wheel disposed on the lower surface of an annular support member is in wide use.

However, the conventional semiconductor wafer back grinding method has the following problems to be solved: The outer peripheral edge of the semiconductor wafer has a cross section of a nearly semicircular shape intended to prevent the occurrence of chipping in a peripheral edge portion of the semiconductor wafer when performing various steps for applying a circuit in each of the plural rectangular regions demarcated on the face of the semiconductor wafer. Thus, when the semiconductor wafer is attracted to the flat surface of the chuck, with the face of the semiconductor wafer being exposed upward, for the purpose of grinding the back of the semiconductor wafer, some gap is formed between the chuck surface and the semiconductor wafer face in the outer peripheral edge of the semiconductor wafer. According to our (the present inventors') experience, when grinding is performed with the grinding means being pressed against the back of the semiconductor wafer, subtle vibrations are caused in the outer peripheral edge portion of the semiconductor wafer owing to the above gap, whereby chipping tends to occur in the outer peripheral edge portion of the semiconductor wafer. Recently, it has frequently been desired to make the semiconductor wafer as thin as 30 to 100 µm for light weight and compactness of semiconductor chips. Grinding of the semiconductor wafer to such thinness increases the tendency toward occurrence of chipping in the outer peripheral edge portion of the semiconductor wafer, and imparts an undesirable sharp knife edge to the outer peripheral edge of the semiconductor wafer.

Japanese Unexamined Patent Publication No. 1996-37169 proposes grinding the outer peripheral edge portion of the back of the semiconductor wafer to a truncated conical shape, in which this outer peripheral edge portion is inclined radially outwardly toward the face of the semiconductor wafer, prior to grinding of the back of the semiconductor wafer, in order to avoid the formation of a sharp knife edge at the outer peripheral edge of the semiconductor wafer during thinning of the semiconductor wafer by grinding of the back of the semiconductor wafer. According to this proposal, the outer peripheral edge of the semiconductor wafer, after grinding of the back of the semiconductor wafer, obtains a nearly semicircular sectional shape, so that the formation of a sharp knife edge is avoided. However, some gap still exists between the chuck surface and the semiconductor wafer face in the outer peripheral edge portion of the semiconductor wafer. In addition, the outer peripheral edge portion of the semiconductor wafer becomes locally thin compared with other portions of the semiconductor wafer, because of grinding of the outer peripheral edge portion of the back of the semiconductor wafer in the above-mentioned manner. Hence, the tendency toward occurrence of chipping in the outer peripheral edge portion of the semiconductor wafer during grinding of the back of the semiconductor wafer is not avoided, but is increased.

### Disclosure of the Invention

It is, therefore, a principal object of the present invention to provide a novel and improved method for grinding the back of a semiconductor wafer, the method being capable of reliably avoiding the formation of a sharp knife edge at the outer peripheral edge of a semiconductor wafer as a result of grinding the back of the semiconductor wafer, and the method being also capable of preventing or suppressing the occurrence of chipping in an outer peripheral edge portion of the semiconductor wafer during grinding of the back of the semiconductor wafer.

According to the present invention, in order to attain the above principal object, pretreatment for forming the outer peripheral edge of a semiconductor wafer into a flat surface making an angle θ, such that 80 degrees ≤ θ ≤ 100 degrees, with respect to the back of the semiconductor wafer is applied before the back of the semiconductor wafer is ground.

That is, according to the present invention, there is provided, as a semiconductor wafer back grinding method for attaining the above principal object, a semiconductor wafer back grinding method which grinds, by grinding means, the back of a semiconductor wafer having a plurality of circuits formed on its face and having an outer peripheral edge of a nearly semicircular sectional shape, thereby bringing the semiconductor wafer to a predetermined thickness, characterized in that
pretreatment for forming the outer peripheral edge of the semiconductor wafer into a flat surface making an angle θ, such that 80 degrees ≤ θ ≤ 100 degrees, with respect to the back of the semiconductor wafer is applied before the back of the semiconductor wafer is ground.

It is preferred that 85 degrees ≤ θ ≤ 95 degrees. The pretreatment can be performed by cutting the outer peripheral edge of the semiconductor wafer by a rotary cutting tool, or by grinding the outer peripheral edge of the semiconductor wafer by a rotary grinding tool. In preferred embodiments, before or after the pretreatment is applied, a protective tape is stuck to the face of the semiconductor wafer, and the outer peripheral edge of the protective tape is substantially aligned with the outer peripheral edge of the semiconductor wafer. If a protective coating for protecting the plurality of circuits is applied to the face of the semiconductor wafer, except for an outer peripheral edge portion of the face of the semiconductor wafer, the outer peripheral edge of the protective coating is substantially aligned with the outer peripheral edge of the semiconductor wafer in the pretreatment.

### Brief Description of the Drawings

FIG. 1 is a perspective view showing a typical example of a semiconductor wafer whose back is ground by the back grinding method of the present invention.
FIG. 2 is a sectional view showing a peripheral edge portion of the semiconductor wafer of FIG. 1.
FIG. 3 is a sectional view showing a state of the semiconductor wafer of FIG. 1 placed on a chuck, with the back of the semiconductor wafer being directed upward after a protective tape is stuck to the face of the semiconductor wafer.
FIG. 4 is a sectional view showing one mode of pretreatment applied to the outer peripheral edge of the semiconductor wafer of FIG. 1.
FIG. 5 is a sectional view showing another mode of pretreatment applied to the outer peripheral edge of the semiconductor wafer of FIG. 1.
FIG. 6 is a sectional view showing the mode of grinding the back of the semiconductor wafer of FIG. 1 after pretreatment is applied to its outer peripheral edge.
FIG. 7 is a sectional view showing the semiconductor wafer having a protective coating applied to its face.

### Best Mode for Carrying Out the Invention

Preferred embodiments of the semiconductor wafer back grinding method of the present invention will be described in detail by reference to the accompanying drawings.

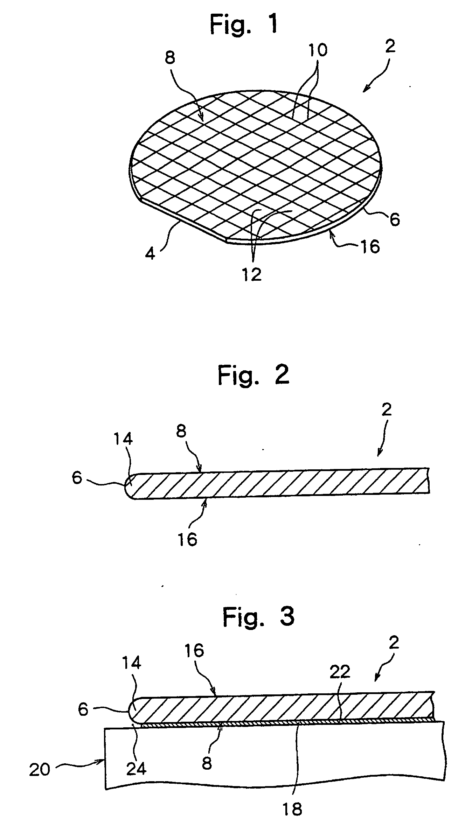

FIGS. 1 and 2 show a typical example of a semiconductor wafer to which the method of the present invention is applied. A semiconductor wafer 2, which can be formed of silicon, is nearly disk-shaped, and has an outer peripheral edge 6 of an arcuate shape, except for a straight edge 4 called an orientation flat. A V-shaped notch (not shown), called an orientation notch, may be disposed instead of the straight edge 4 called an orientation flat. A plurality of rectangular regions 12 are demarcated by a plurality of streets 10 arranged in a lattice pattern on the face 8 of the semiconductor wafer 2. A suitable circuit is formed in each of the rectangular regions 12. As is clearly shown in FIG. 2, the arcuate outer peripheral edge 6 of the semiconductor wafer 2 is usually in a nearly semicircular shape in order to avoid the occurrence of chipping at the outer peripheral edge 6 during transport, etc. of the semiconductor wafer 2. Thus, the sectional shape of an outer peripheral edge portion 14 of the semiconductor wafer 2 is a nearly semispherical shape. The straight edge 4 is formed into a flat surface extending substantially perpendicularly to the face 8 and a back 16, or into a nearly semicircular shape like the outer peripheral edge 6.

Explanation will continue by reference to FIG. 3 along with FIGS. 1 and 2. In preferred embodiments of the present invention, when the back 16 of the semiconductor wafer 2 is to be ground to make the semiconductor wafer 2 have a predetermined thickness, a protective tape 18 is stuck onto the face 8 of the semiconductor wafer 2. Normally, the protective tape 18 is stuck except for the outer peripheral edge portion 14 of the face 8 of the semiconductor wafer 2, so that the protective tape 18 does not exist on the outer peripheral edge portion 14. The protective tape 18, which is stuck to the face 8 of the semiconductor wafer 2 via a suitable adhesive, can be formed from a suitable plastic film or sheet, a thin metal plate, or a thin ceramic plate.

After the protective tape 18 is stuck to the face 8 of the semiconductor wafer 2, the semiconductor wafer 2 is attracted to an upper surface 22 of a chuck 20, with the back 16 of the semiconductor wafer 2 being exposed upward. The chuck 20, which may be in a well known form per se, has the flat upper surface 22 having suction holes or suction grooves (not shown) formed therein, and vacuum-attracts the semiconductor wafer 2 placed on the upper surface 22. As will be understood by reference to FIG. 2, the outer peripheral edge 6 of the semiconductor wafer 2 has a semicircular sectional shape. Thus, some gap 24 is present between the outer peripheral edge portion 14 of the face 8 of the semiconductor wafer 2 and the upper surface 22 of the chuck 20.

In the present invention, it is important that pretreatment is applied to the outer peripheral surface 6 of the semiconductor wafer 2 before grinding of the back 16 of the semiconductor wafer 2, whereby the outer peripheral edge 6 of the semiconductor wafer 2 is formed into a flat surface making an angle θ being 80 degrees ≤ θ ≤ 100 degrees, preferably 85 degrees ≤ θ ≤ 95 degrees, with respect to the back 16.

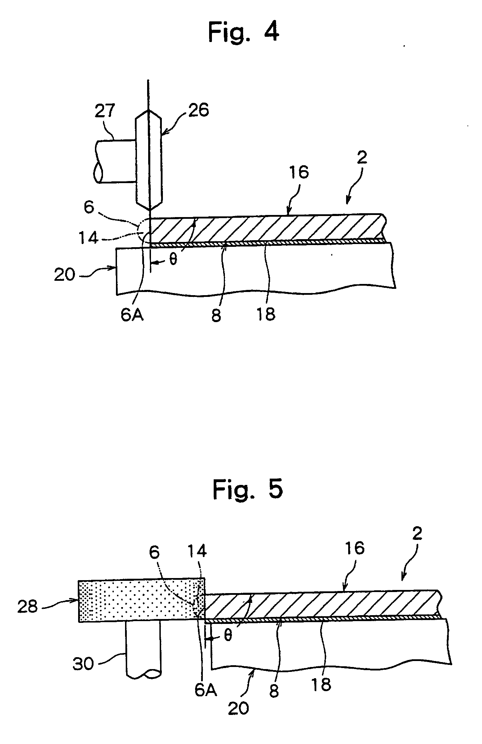

Such pretreatment can be performed by cutting the outer peripheral edge portion 14 of the semiconductor wafer 2 by a rotary cutting tool 26, as illustrated in FIG. 4. Advantageously, the rotary cutting tool 26 is constituted by a thin-walled annular blade well known per se and containing diamond abrasive grains. The rotary cutting tool 26 is mounted on a spindle 27 and rotationally driven at a high speed, with its peripheral edge portion acting on the outer peripheral edge portion 14 of the semiconductor wafer 2. The chuck 20 is rotated at a predetermined speed, whereby the outer peripheral edge portion 14 of the semiconductor wafer 2 is cut into an arcuate shape. If the rotation axis of the chuck 20 and the rotation axis of the rotary cutting tool 26 are perpendicular to each other, the cut outer peripheral edge 6 of the semiconductor wafer 2 is formed into a flat surface at an angle θ of 90 degrees with respect to the back 16. To form the outer peripheral edge 6A into a flat surface slightly inclined with respect to the back 16, it suffices to slant the rotation axis of the rotary cutting tool 26 slightly with respect to the rotation axis of the chuck 20. Preferably, cutting of the outer peripheral edge portion 14 of the semiconductor wafer 2 is carried out in alignment with the outer peripheral edge of the protective tape 18, and the so cut outer peripheral edge 6A aligns with the outer peripheral edge of the protective tape 18. If desired, an outer peripheral edge portion of the protective tape 18 may also be cut simultaneously with the outer peripheral edge portion of the semiconductor wafer 2, whereby the outer peripheral edge 6A of the semiconductor wafer 2 and the outer peripheral edge of the protective tape 18 can be brought into alignment.

If not only the arcuate outer peripheral edge 6 of the semiconductor wafer 2, but also its straight edge 4 has a nearly semicircular sectional shape, the straight edge 4 is similarly cut and thereby can be formed into a flat surface having the angle 8 with respect to the back 16. At this time, the chuck 20 is moved in a straight line relative to the rotary cutting tool 26 to cut the semiconductor wafer 2 along the straight edge 4. In the illustrated embodiment, the protective tape 18 is stuck to the face 8 of the semiconductor wafer 2 before pretreatment is applied to the outer peripheral edge 6 of the semiconductor wafer 2. If desired, however, the protective tape 18 can be stuck to the face 8 of the semiconductor wafer 2 after pretreatment is applied to the outer peripheral edge 6 of the semiconductor wafer 2.

Pretreatment of the outer peripheral edge 6 of the semiconductor wafer 2 can also be performed by grinding the outer peripheral edge 6 of the semiconductor wafer 2 by a rotary grinding tool 28, as shown in FIG. 5. The illustrated rotary grinding tool 28 is composed of an annular grinding tool containing diamond abrasive grains, and mounted on a spindle 30. The rotary grinding tool 28 is rotated at a high speed, and its circumferential surface is pressed against the outer peripheral edge 6 of the semiconductor wafer 2. The chuck 20 having attracted the semiconductor wafer 2 is also rotated, so that grinding is carried out along the outer peripheral edge 6 of the semiconductor wafer 2. If the rotation axis of the chuck 20 and the rotation axis of the rotary grinding tool 28 are parallel, the ground outer peripheral edge 6A of the semiconductor wafer 2 is formed into a flat surface having an angle θ of 90 degrees to the back 16. To form the outer peripheral edge 6A into a flat surface slightly inclined with respect to the back 16, it suffices to slant the rotation axis of the rotary grinding tool 28 slightly with respect to the rotation axis of the chuck 20.

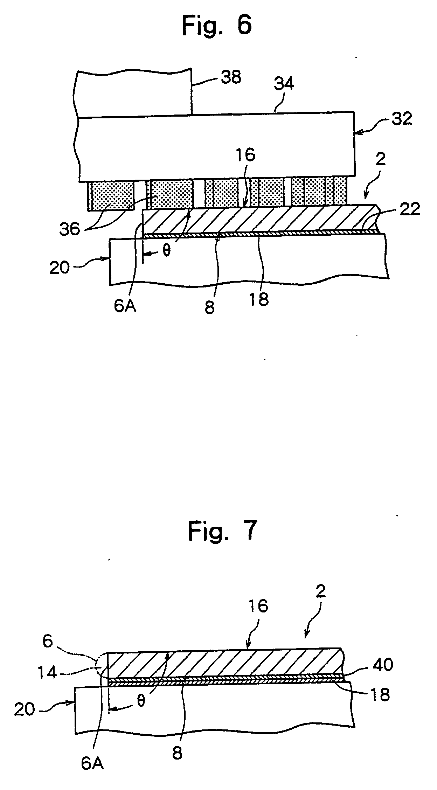

In the present invention, after the above-described pretreatment is applied to the outer peripheral edge 6 of the semiconductor wafer 2, the back 16 of the semiconductor wafer 2 is ground to bring the semiconductor wafer 2 to a predetermined thickness. FIG. 6 shows a mode of grinding the back of the semiconductor wafer 2 by grinding means 32. The illustrated grinding means 32 is composed of an annular support member 34, and a plurality of arcuate grinding pieces 36 fixed to the lower surface of the support member 34 with spacing in the circumferential direction. The arcuate grinding piece 36 may be a grinding piece containing diamond abrasive grains. The grinding means 32 is mounted to the lower end of a spindle 38. The grinding means 32 is rotated at a high speed, and pressed against the back 16 of the semiconductor wafer 2 attracted onto the upper surface 22 of the chuck 20. The chuck 20 is also rotated at a predetermined speed. Thus, the back 16 of the semiconductor wafer 2 is ground by the grinding means 32. Since the outer peripheral edge 6A of the semiconductor wafer 2 is formed into a flat surface making the angle θ with the back 16, substantially no gap exists between the face of the semiconductor wafer 2 and the upper surface 22 of the chuck 20. Hence, the back 16 of the semiconductor wafer 2 can be ground, with occurrence of chipping in the outer peripheral edge 6A of the semiconductor wafer 2 being avoided or suppressed. Moreover, the outer peripheral edge 6A of the semiconductor wafer 2 is formed into a flat surface making the angle θ with the back 16. Even when the semiconductor wafer 2 is ground to a predetermined thickness, therefore, the outer peripheral edge 6A is a flat surface, and a sharp knife edge is not produced there.

FIG. 7 shows another embodiment of the semiconductor wafer 2. In the semiconductor wafer 2 illustrated in FIG. 7, a protective coating 40, which can be formed from a suitable synthetic resin, such as polyimide, is applied to the face 10 of the semiconductor wafer 2 in order to protect circuits formed on the face. The protective coating 40 is applied, except for the outer peripheral edge portion 14 of the face 10 of the semiconductor wafer 2. Thus, the protective coating 40 is not applied in the outer peripheral edge portion 14 of the semiconductor wafer 2. In the case of the semiconductor wafer 2 having the protective coating 40 applied thereto, as shown in FIG. 7, after the protective tape 18 is further stuck, where necessary, onto the protective coating 40, pretreatment is applied to the outer peripheral edge 6 of the semiconductor wafer 2 to form the outer peripheral edge 6 of the semiconductor wafer 2 into a flat surface making the angle θ with the back 16 and also bring the outer peripheral edge 6 of the semiconductor wafer 2 into alignment with the outer peripheral edge of the protective coating 40 (and the protective tape 18 applied as desired).

The preferred embodiments of the semiconductor wafer back grinding method of the present invention have been described in detail above with reference to the accompanying drawings. However, it should be understood that the present invention is not limited to these embodiments, and various modifications and corrections may be made without departing from the scope of the present invention.

## Claims

1. A semiconductor wafer back grinding method which grinds, by grinding means, a back of a semiconductor wafer having a plurality of circuits formed on a face thereof and having an outer peripheral edge of a nearly semicircular sectional shape, thereby bringing the semiconductor wafer to a predetermined thickness, **characterized in that**
pretreatment for forming the outer peripheral edge of the semiconductor wafer into a flat surface making an angle θ, such that 80 degrees ≤ θ ≤ 100 degrees, with respect to the back of the semiconductor wafer is applied before the back of the semiconductor wafer is ground.

2. The semiconductor wafer back grinding method according to claim 1, wherein 85 degrees ≤ θ ≤ 95 degrees.

3. The semiconductor wafer back grinding method according to claim 1, wherein said pretreatment is performed by cutting the outer peripheral edge of the semiconductor wafer by a rotary cutting tool.

4. The semiconductor wafer back grinding method according to claim 1, wherein said pretreatment is performed by grinding the outer peripheral edge of the semiconductor wafer by a rotary grinding tool.

5. The semiconductor wafer back grinding method according to claim 1, wherein before or after said pretreatment is applied, a protective tape is stuck to the face of the semiconductor wafer, and an outer peripheral edge of said protective tape is substantially aligned with the outer peripheral edge of the semiconductor wafer.

6. The semiconductor wafer back grinding method according to claim 1, wherein a protective coating for protecting the plurality of circuits is applied to the face of the semiconductor wafer, except for an outer peripheral edge portion of the face of the semiconductor wafer, and an outer peripheral edge of said protective coating is substantially aligned with the outer peripheral edge of the semiconductor wafer in said pretreatment.
